Europäisches Patentamt

European Patent Office

Office européen des brevets

(11) Veröffentlichungsnummer: **0 080 164**
A2

## (12) EUROPÄISCHE PATENTANMELDUNG

(21) Anmeldenummer: 82110621.8

(22) Anmeldetag: 18.11.82

(51) Int. Cl.³: **H 01 M 10/44**, G 01 R 31/36

(30) Priorität: 21.11.81 DE 3146141

(43) Veröffentlichungstag der Anmeldung: 01.06.83
Patentblatt 83/22

(84) Benannte Vertragsstaaten: FR GB IT SE

(71) Anmelder: BROWN, BOVERI & CIE Aktiengesellschaft,
Kallstadter Strasse 1, D-6800 Mannheim 31 (DE)

(72) Erfinder: Kahlen, Hans, Dr., Holbeinstrasse 11,
D-6940 Weinheim-Sulzbach (DE)

(74) Vertreter: Kempe, Wolfgang, Dr. et al, c/o Brown, Boveri
& Cie AG Postfach 351, D-6800 Mannheim 1 (DE)

(54) Überwachungseinrichtung für eine Batterie.

(57) Eine Batterie, insbesondere ein Akkumulator mit wässrigen Elektrolyten oder eine Hochenergiebatterie, wird hinsichtlich Störungen beim Betrieb der Batterie und Ausfallen einzelner Batteriezellen überwacht. Hierfür wird die Symmetrie der Batterie überwacht und ausgewertet, indem die Batterie aus wenigstens zwei gleichen in Reihe geschalteten Batterieteilen (10) gebildet ist und an den elektrischen Anschlüssen (11, 12, 13) der einzelnen Batterieteile (10) elektrische Leitungen (14) angeschlossen sind, die mit einer Schaltungsanordnung (15) zur Messung der Differenzspannung zwischen jeweils zwei Batterieteilen (10) elektrisch verbunden sind. Aus der Differenz zwischen zwei Batterieteilen (10) können Rückschlüsse auf den Zustand der Batterieteile (10) gezogen werden.

B R O W N , B O V E R I & C I E   AKTIENGESELLSCHAFT
Mannheim                              16. Nov. 1981
Mp.-Nr. 679/81                       ZPT/P2-La/Br

## Überwachungseinrichtung für eine Batterie

Die Erfindung betrifft eine Überwachungseinrichtung für eine Batterie, insbesondere eines Akkumulators mit wässrigem Elektrolyten oder einer Hochenergiebatterie, wie z.B. Na/S-Batterie.

Batterien bestehen aus einer Reihen- und/oder Parallelschaltung einzelner Zellen. Eine Störung infolge Kurzschluß oder Unterbrechung einer Zelle oder infolge eines Kontaktfehlers zwischen zwei Zellen ist in vielen Fällen nicht unmittelbar durch Messung des Anschlußstromes oder der Anschlußspannung feststellbar. Solch eine Störung beeinträchtigt jedoch die Leistungsfähigkeit der Batterie und kann weitere Störungen an anderen Zellen nach sich ziehen, so daß das rechtzeitige Erkennen dieser Störungen wünschenswert ist und in vielen Fällen gefordert werden muß. Einfache Messmethoden für eine Dauerüberwachung serienmäßig hergestellter Batterien sind jedoch nicht bekannt geworden.

Ferner muß beim Laden einer Batterie davon ausgegangen

werden, daß nicht alle Zellen gleichzeitig voll geladen werden. Zellen, die mit anderen Zellen in Reihe geschaltet sind, werden auch dann noch vom Ladestrom durchflossen, wenn sie voll geladen sind. Bei Batteriezellen mit wässrigen Elektrolyten, wie bei Bleiakkumulatoren, wird dabei die Gasungsspannung erreicht. Die Zelle kann keine weitere Engerie mehr speichern. Der eingeprägte Ladestrom führt zu einer Wasserzersetzung, wodurch die zugeführte Energie abgeführt wird.

Auch bei Hochenergiebatterien wie Natrium-Schwefel-Batterien oder Lithium-Schwefel-Batterien treten Probleme auf, wenn einzelne Zellen voll geladen sind, ohne daß das Laden der Batterie abgebrochen bzw. der Ladestrom reduziert wird. Hochenergiebatterien haben hermetisch geschlossene Zellen. Eine Gasung darf nicht auftreten. Natrium-Schwefel-Zellen können im Gegensatz zu anderen Hochenergieakkuzellen, wenn sie voll geladen sind, eine höhere Zellspannung aufnehmen. Bei der Natrium-Schwefel-Batterie kann diese Spannung z.B. kurzzeitig bis 20V betragen, gegenüber 2,08V Leerlaufzellspannung. Damit treten bei eingeprägtem Ladestrom Verluste auf, die eine Temperaturerhöhung bewirken.

Beim Entladen einer Batterie sind nicht immer alle Zellen gleichzeitig entladen. Zellen, die mit anderen Zellen in Reihe geschaltet sind, werden jedoch auch dann vom Entladestrom durchflossen, wenn sie bereits entladen sind. Bei den meisten Batteriezellen erhöht sich dabei der Innenwiderstand. Der eingeprägte Entladestrom bewirkt bei entladener Zelle eine Spannungsumkehr. Dies kann bei Batterien mit wässrigen Eletrolyten wie Bleiakkumulatoren zur Umpolung der Platten führen und die Batterie beschädigen oder zerstören. Bei Natrium-Schwefel-Zellen führt eine Überentladung ebenfalls zur Beschädigung oder Zerstörung der Zellen.

Um ein Überladen bzw. Überentladen von Zellen einer Batterie zu vermeiden, wurden daher durch die DE-OS 28 19 584 und die DE-OS 28 38 996 Schaltungen angegeben, bei denen jeder in Serie geschalteten Speicherzelle oder jeder Gruppe von Speicherzellen mindestens je ein Schutzelement parallel geschaltet ist. Dies erfordert ggf. eine hohe Anzahl von Schutzelementen, deren insbesondere nachträgliche Montage sehr aufwendig ist.

Aufgabe der Erfindung ist es, eine Überwachungseinrichtung für Batterien nach dem Oberbegriff des Anspruches 1 zu schaffen, die Störungen beim Betrieb der Batterie und das Ausfallen einzelner Batteriezellen meldet, sowie Hinweise abgibt, in welchen Batterieteilen sich die Fehler-oder Störquellen befinden, und die eine Kontrolle von Lade- und Entladevorgängen ermöglicht.

Die Aufgabe der Erfindung wird dadurch gelöst, daß die Symmetrie der Batterie überwacht und ausgewertet wird, insbesondere, daß die Batterie aus wenigstens zwei gleichen in Reihe geschalteten Batterieteilen gebildet ist, und daß an die elektrischen Anschlüsse der einzelnen Batterieteile elektrische Leitungen angeschlossen sind, die mit einer Schaltungsanordnung zur Messung der Differenzspannung zwischen jeweils zwei Batterieteilen elektrisch verbunden sind.

Aus der Differenzspannung zwischen zwei Batterieteilen können Rückschlüsse auf den Zustand der Batterieteile gezogen werden. Arbeiten beide Batterieteile fehlerfrei, so ist die Differenzspannung in allen stationären Betriebszuständen Null. Bei Auftreten eines Kurzschlusses in einer Zelle, einer Erhöhung des Innenwiderstandes einer Zelle, eines Kontaktfehlers zwischen zwei Zellen, Überladung oder Überentladung einer Zelle weicht die Differenzspannung von Null ab. Aus der Höhe und Polarität der Differenzspannung sowie des jeweiligen Betriebszustandes der Batterie kann die Art des Fehlers ermittelt und der Batterieteil, in dem der Fehler auftritt, festgestellt werden. Lediglich in dem sehr seltenen Fall, bei dem in den miteinander verglichenen Batterieteilen gleichzeitig die gleiche Fehlerart auftritt, bleibt die Differenzspannung Null und die Fehler werden nicht registriert.

Einer Ausgestaltung der Erfindung zufolge ist die Schaltungsanordnung zur Messung der Differenzspannung derart ausgeführt, daß an den elektrischen Anschlüssen jedes Batterieteiles ein Spannungsmeßgerät angeschlossen ist, deren Ausgänge mit einer Diagnoseeinrichtung verbunden sind, die die Meßwerte der Spannungsmeßgeräte miteinander vergleicht und hinsichtlich möglicher Fehlerursachen auswertet, in dem sie feststellt, ob eine Differenzspannung zwischen zwei Batterieteilen auftritt und ggf. welchen Wert und welche Polarität diese aufweist, und die entsprechende Steuer- und/oder Überwachungssignale abgibt.

Die Diagnoseeinrichtung kann entweder so ausgelegt sein, daß sie jeweils nur eine Differenzspannung zwischen zwei (z.B. in der Reihenschaltung hintereinanderliegende) Batterieteile bildet, oder auch so, daß die Differenzspannung zwischen einem Batterieteil und mehreren anderen Batterieteilen ermittelt und ausgewertet werden.

Sofern wenigstens eine Differeinzspannung von Null verschieden ist, liegt eine Störung vor. Die Diagnoseeinrichtung ermittelt aus dem Wert und der Polarität sowie dem jeweiligen Betriebszustand die Art der Störung und den Batterieteil, in dem die Störung aufgetreten ist.

Der Wert der Differenzspannung ist darüber hinaus wesentlich von dem inneren Aufbau der gleichen Batterieteile abhängig. Handelt es sich hierbei um eine Reihenschaltung von Zellen, so ist die Auswertung einer Differenzspannung relativ übersichtlich. In der Beschreibung wird dieses Beispiel näher erläutert.

Die durch die Diagnoseeinrichtung abgegebenen Signale können z.B. dazu verwendet werden, die Batterie abzuschalten, die Belastung oder den Ladevorgang der Batterie zu steuern und/oder optische und akkustische Signale zu erzeugen, die über den Zustand der Batterie Auskunft geben.

Eine weitere vorteilhafte Ausgestaltung der Erfindung ist durch eine Schaltungsanordnung zur Messung der Differenzspannung jeweils zweier direkt hintereinander geschalteter Batterieteile gegeben, bei der jeweils parallel zu den beiden Batterieteilen zwei in Reihe liegende Widerstände, insbesondere mit gleichem Widerstandswert, angeschlossen sind, und bei der zwischen dem Mittelabgriff der beiden Batterieteile und einem entsprechenden Mittelabgriff zwischen den Widerständen ein Spannungsmeßgerät angeschlossen ist.

Durch diese Anordnung kann die Differenzspannung zwischen zwei in der Reihenschaltung benachbarte Batterieteile direkt gemessen werden.

Die Auswertung dieser Spannungsdifferenzen erfolgt in vorteilhafter Weise wiederum durch eine Diagnoseeinrichtung, welche die Differenzspannung hinsichtlich Wert und Polarität auswertet und Steuer- und/oder Überwachungssignale abgibt.

Vorzugsweise sind die Spannungs- bzw. Differenzsspan-

nungsmeßgeräte elektronische Differenzverstärker. Die Überwachungseinrichtung kann auch aus einem oder mehreren integrierten Bauelementen aufgebaut werden.

Gemäß einer weiteren vorteilhaften Ausgestaltung der Erfindung erfolgt die Stromversorgung der Überwachungseinrichtung, insbesondere der Differenzverstärker und/oder integrierten Bauelemente durch die zu überwachende Batterie. Beispielsweise kann die Stromversorgung von Differenzverstärkern, die als Differenzspannungsmeßgeräte in einer Schaltungsanordnung gemäß Anspruch 3 angeordnet sind, mit den Spannungsteilerwiderständen kombiniert werden.

An Hand der Zeichnung, in der mehrere Ausführungsbeispiele der Erfindung gezeigt sind, soll die Erfindung sowie weitere vorteilhafte Ausgestaltungen und Weiterbildungen näher erläutert werden.

Es zeigen:

Fig.1          eine Reihenschaltung von Batterieteilen mit einer Schaltungsanordnung zur Messung und Auswertung der Spannungen der einzelnen Batterieteile,

Fig.2          eine Reihenschaltung von Batterieteilen mit einer Schaltungsanordnung zur Messung und Auswertung der Differenzspannungen jeweils zweier direkt hintereinander geschalteter Batterieteile,

Fig.3 und 4    je eine Reihenschaltung von zwei Batterieteilen mit einer Meßeinrichtung zur Messung der Differenzspannung der beiden Batterieteile.

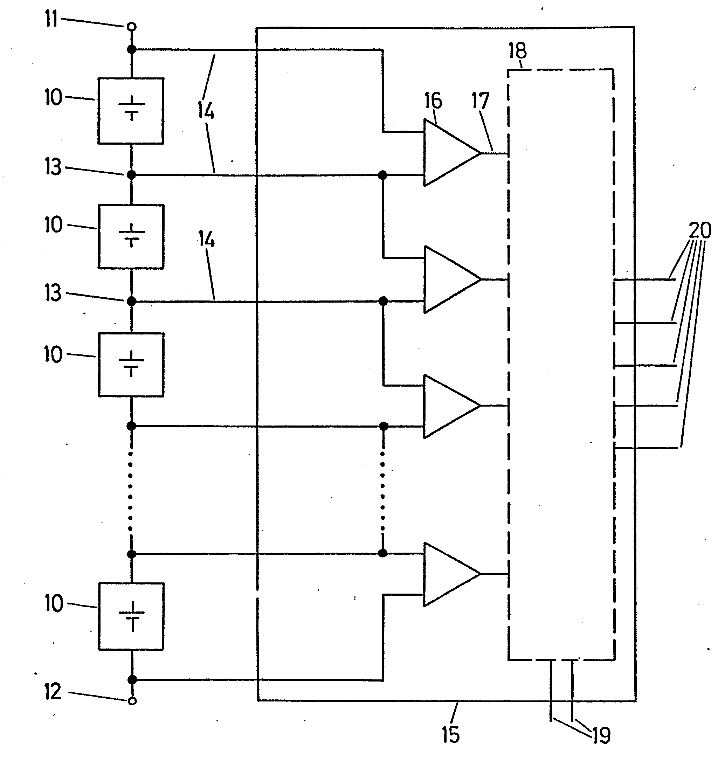

In der Fig. 1 ist eine Batterie dargestellt, die aus einer Reihenschaltung von vier Batterieteilen 10 gebildet ist, wobei die punktierten Linien andeuten sollen, daß die Anzahl der in Reihe geschalteten Batterieteile 10 beliebig, jedoch wenigstens zwei ist. Der innere Aufbau sowie der Ladezustand der Batterieteile 10 ist identisch. Die Batterieteile 10 können aus in Reihe und/oder parallel geschalteten Zellen aufgebaut sein.

Die in Reihe geschalteten Batterieteile liegen zwischen zwei Batterieanschlußklemmen 11, 12. Sowohl an diesen Anschlußklemmen 11, 12 als auch an Mittelabgriffen 13, die jeweils zwischen zwei benachbarter Batterieteilen 10 liegen, sind elektrische Leitungen 14 angeschlossen, die mit einer Schaltungsanordnung 15 verbunden sind.

Innerhalb der Schaltungsanordnung 15 ist parallel zu jedem Batterieteil 10 je ein Differenzverstärker 16 angeschlossen, der die Spannung des jeweiligen Batterieteils 10 mißt. Die Beschaltung der Differenzverstärker ist dem Stand der Technik zu entnehmen und wurde nicht näher dargestellt. Über die Ausgangsleitungen 17 der Differenzverstärker 16 werden die Spannungsmeßwerte der Batterieteile 10 einer Diagnoseeinrichtung 18, die durch eine gestrichelte Linie dargestellt ist, zugeführt. Die Diagnoseeinrichtung 18 erhält darüber hinaus über zusätzliche Zuleitungen 19 Informationen über den Betriebszustand (Ladestrom, Entladestrom) der Batterie.

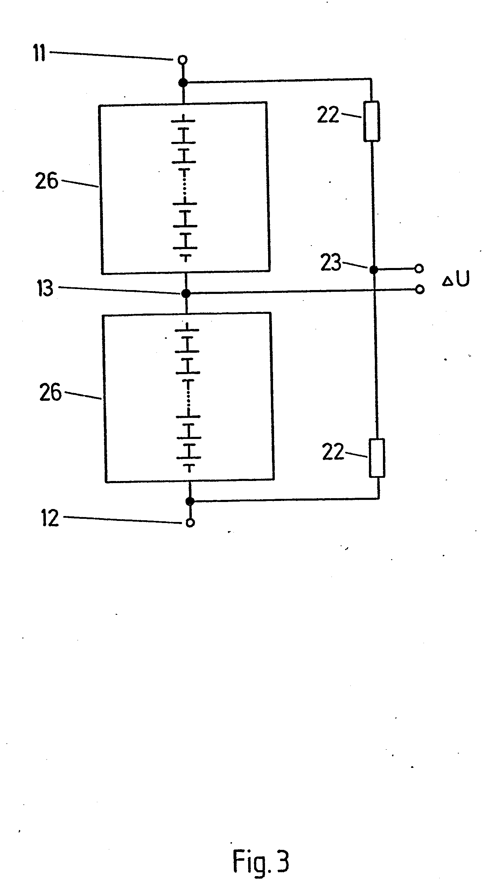

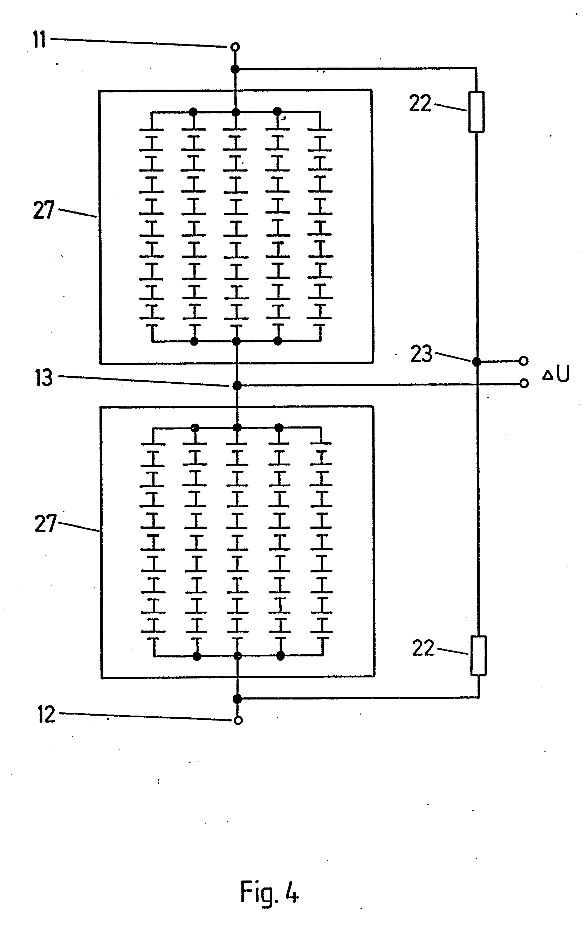

Innerhalb der Diagnoseeinrichtung 18 werden die Spannungswerte der Batterieteile 10 miteinander verglichen. Aus dem Auftreten von Differenzspannungen zwischen zwei beliebigen Batterieteilen 10, aus deren Wert und Polarität sowie aus dem Betriebszustand der Batterie werden Rückschlüsse auf Fehler oder Störquellen in den Batterieteilen 10 gezogen. Welchen Einfluß Fehler- oder Störungen in einem Batterieteil 10 auf die Ausbildung einer Differenzspannung bei Vergleich mit einem voll funktionsfähigen Batterieteil 10 haben, wird weiter unten anhand der Beschreibung zu Fig. 3 und Fig. 4 an zwei Beispielen dargestellt.

Die Diagnoseeinrichtung 18 gibt gemäß der ermittelten Fehler- oder Störquellen Überwachungs- und/oder Steuersignale über entsprechende Steuerleitungen 20 ab. Die Überwachungssignale können bsw. optische oder akkustische Signale auslösen, die melden, ob eine Störung in wenigstens einem Batterieteil 10 auftritt, um welches Batterieteil 10 es sich hierbei handelt und welcher Art die Störung ist. Es kann z.B. ein Kurzschluß oder eine Unterbrechung einer Zelle des Batterieteils 10, ein Kontaktfehler innerhalb des Batterieteils 10 oder die vollständige Ladung bzw. Entladung wenigstens einer Zelle des Batterieteiles 10 gemeldet werden. Die Überwachungssignale können jedoch auch zu einer Steuerung des Batteriebetriebs genutzt werden und bsw. eine Abschaltung oder Reduzierung des Ladestromes bewirken.

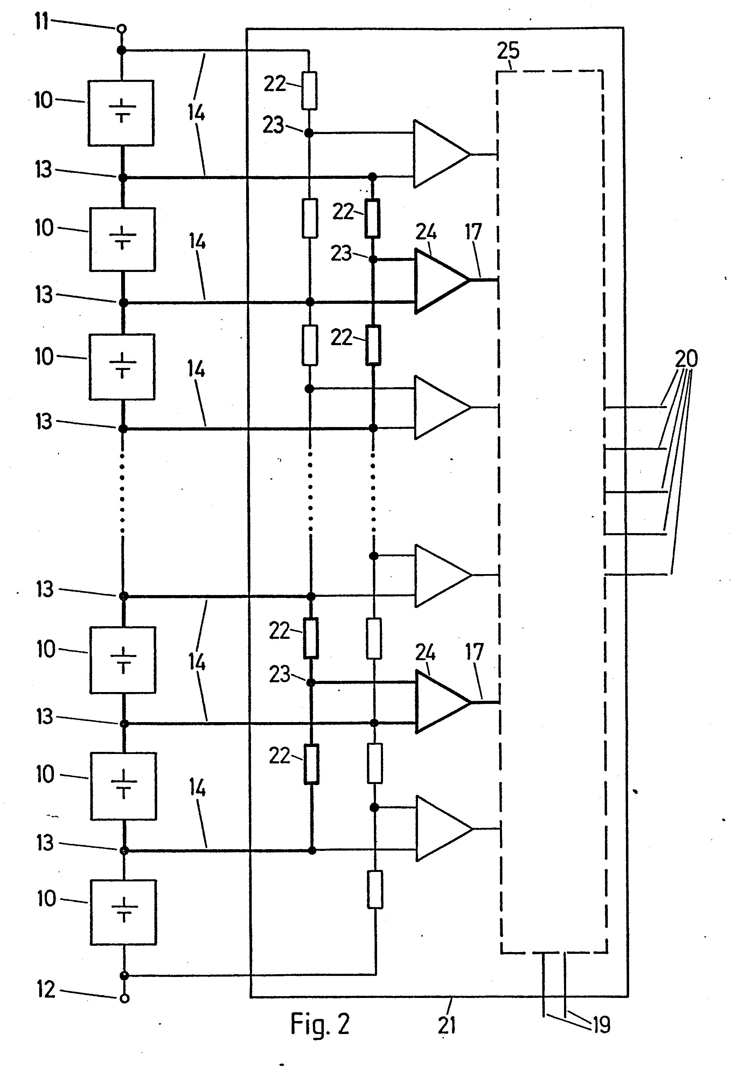

Die Differenzspannungsmessung gemäß Fig 2 unterscheidet sich von der in Fig. 1 dargestellten dadurch, daß hier unter Umgehung der Spannungsmessung der einzelnen Batterieteile direkt Differenzspannungen gemessen werden. Die Schaltungsanordnung 21 gemäß Fig. 2 erlaubt jedoch nur die Messung von Differenzspannungen zweier direkt hintereinandergeschalteter Batterieteile 10. Um die entsprechende Schaltungsanordnung zu verdeutlichen, sind zwei Differenzspannungsmeßanordnungen durch starke Linien hervorgehoben.

Jeweils zu zwei direkt hintereinandergeschalteten Batterieteilen 10 sind zwei in Reihe liegende Widerstände 22 angeschlossen. Diese haben untereinander den gleichen Widerstandswert und sind hochohmig, um eine Entladung der Batterieteile 10 weitgehend zu vermeiden. Zwischen dem Mittelabgriff 13 jeweils zweier benachbarter Batterieteile 10 und einem Mittelabgriff 23 zwischen den beiden zugehörigen Widerständen 22 ist ein Differenzverstärker 24 geschaltet, der direkt die Differenzspannung zwischen den beiden Batterieteilen 10 mißt. Die Meßwerte werden über Ausgangsleitungen 17 einer Diagnoseeinrichtung 25 zugeführt, die im wesentlichen die gleiche Meßwertauswertung wie die zu Fig. 1 beschriebene vornimmt.

An Hand der Fig. 3, die eine einfache Schaltung mit einer Batterie, welche aus zwei Batterieteilen 26 besteht, zeigt, soll ein Rechenbeispiel durchgeführt werden, das die Funktionsweise der Differenzspannungsüberwachung veranschaulicht. Die beiden Batterieteile 26 sind identisch und bestehen je aus einer Reihenschaltung von $n=50$ Zellen mit der Leerlaufzellenspannung $U_{LZ}=2V$ und einem Innenwiderstand der Zelle $R_i=1mOhm$. Als Entladestrom wird $I_E=100A$ und als Ladestrom $I_L=40A$ gewählt. Die beiden Batterieteile 26 sind in Reihe geschaltet und weisen zwei Batterieanschlußklemmen 11, 12 auf. Zwischen den Batterieteilen 26 befindet sich ein Mittelabgriff 13. Parallel zu den beiden Batterieteilen 26 sind an den Batterieanschlußklemmen 11, 12 zwei hochohmige Widerstände 22 mit gleichem Widerstandswert angeschlossen. Zwischen dem Mittelabgriff 13 der beiden Batterieteile 26 und einem Mittelabgriff 23 zwischen den Widerständen 22 wird die Spannungsdifferenz U gemessen.

Es werden folgende Fehler- bzw. Störfälle untersucht:
1. Eine Zelle hat eine Unterbrechung.
In diesem Fall tritt als Spannungsdifferenz die Spannung eines Batterieteils 26 auf, also bei Leerlaufbetrieb die Spannung $U = n \cdot U_{LZ} = 100V$. Laden oder Entladen der Batterie ist wegen der Unterbrechung nicht möglich.

2. Eine Zelle ist kurzgeschlossen.
Die Gesamtspannung der Batterie vermindert sich um den Betrag der Zellspannung $U_Z = U_{LZ} - I \cdot R_{iZ}$, bei Leerlaufbetrieb (I =0), also um 2V, und beträgt $U_B = 198V$. Der Mittelabgriff 23 hat im Leerlaufbetrieb eine Spannung von 99V, während der Mittelabgriff 13 nur 98V aufweist, so daß eine Spannungsdifferenz von $U = U_Z/2 = 1V$ gemessen wird. Durch die Polarität der Spannungsdifferenz kann festgestellt werden, in welchem Batterieteil 26 die kurzgeschlossene Zelle liegt.

3. Der Innenwiderstand einer Zelle ist erhöht.
Dies kann z.B. durch einen Kontaktfehler auftreten. Es sei angenommen, der Innenwiderstand habe sich um $R_ü = 20mOhm$ auf $R_{iZ} + R_ü = 21\ mOhm$ erhöht. Der Gesamtinnenwiderstand der Batterie ist dann $R_B = 120mOhm$. Bei einem Laststrom von $I_E = 100A$ ist der Spannungsabfall über dem Innenwiderstand der Batterie 12V, so daß die Batteriespannung an den Anschlußklemmen 11, 12 $U_B = 88V$ beträgt. In der gestörten Zelle beträgt der zusätzliche Spannungsabfall $20mOhm \cdot 100A = 2V$, so daß zwischen den Mittelabgriffen 13, 23 eine Spannungsdifferenz von $U = - I_E \cdot R_ü/2 = -1V$ auftritt. Auch hier wird durch die Polarität der Spannungsdifferenz festgestellt, in welchem Batterieteil 10 die deffekte Zelle liegt. Bei einem Ladestrom von $I_L = 40A$ ergibt sich eine Spannungsdifferenz mit umgekehrtem Vorzeichen von $U = I_L R_ü/2 = 0,h4V$.

4. Eine Zelle ist vollständig entladen oder geladen.
Der Innenwiderstand der Zelle erhöht sich stark, demzufolge tritt beim Belasten oder Laden der Batterie eine Differenzspannung auf, die wie unter Punkt 3 gezeigt, von der Widerstandserhöhung und der Last- bzw. Ladestrom abhängt.

An Hand der Fig.4 soll ein weiteres Rechenbeispiel durchgeführt werden. Die beiden gleichen Batterieteile 27, die einen gleichen Meßaufbau wie der für Fig.3 beschriebene aufweisen, bestehen jeweils aus einer Reihenschaltung von k = 10 Zellen und Parallelschaltung von l = 5 Reihen. Der Innenwiderstand je Zelle soll $R_{iZ}$ = 5mOhm und die Leerlaufspannung $U_{LZ}$ = 2V betragen. Als Entladestrom wird $I_E$ = 100A und als Ladestrom $I_L$ = 40A gewählt. Es werden folgende Fehler- bzw. Störfälle untersucht:

5. Eine Zelle hat eine Unterbrechung.
Bei Unterbrechung einer Zelle kann im Leerlauf keine Differenzspannung auftreten. Bei Belastung mit $I_E$ = 100A tritt eine Spannungsdifferenz von

$$U = \left( \frac{1}{l} - \frac{1}{l-1} \right) \cdot \frac{k}{2} \cdot R_{iZ} \cdot I_E = 125mV$$

auf.

6. Eine Zelle ist kurzgeschlossen.
In diesem Fall tritt im Leerlauf eine Differenzspannung

von

$$U = \frac{U_{LZ}}{2} \cdot \frac{k}{k + (l-1)(k-1)} \quad 0,22V$$

auf. Auch hier kann, wie in allen Beispielen, aus der Polarität der Differenzspannung auf den gestörten Batterieteil 27 geschlossen werden.

7. Der Innenwiderstand einer Zelle ist erhöht.
Wie beim Fall 5. ist im Leerlauf die Differenzspannung Null. Bei Belastung mit $I_E$ = 100A und einer 20-fachen Widerstandserhöhung der Zelle tritt jedoch eine Spannungsdifferenz von U = 75mV auf.

8. Eine Zelle ist vollständig entladen oder geladen. Dies wirkt sich wie die unter Fall 7. beschriebene Innenwiderstandserhöhung der Zelle aus. Die auftretende Spannungsdifferenz ist sowohl von dem Last- bzw. Ladestrom als auch der Widerstandserhöhung der Zelle abhängig.

An Hand der Beispiele gemäß Fig.3 und Fig.4 wurde gezeigt, daß jede geschilderte Störung zu unterschiedlichen Werten und Verhalten der Differenzspannung führt, so daß umgekehrt aus der Analyse der Differenzspannung auf die Störursache geschlossen werden kann.

A n s p r ü c h e

1. Überwachungseinrichtung für eine Batterie, insbesondere eines Akkumulators mit wässrigem Elektrolyten oder einer Hochenergiebatterie, wie z.B. Na/S-Batterie, dadurch gekennzeichnet, daß die Batterie aus wenigstens zwei in Reihe geschalteten Batterieteilen (10, 26, 27) gebildet ist, und daß an die elektrischen Anschlüsse (11, 12, 13) der einzelnen Batterieteile (10, 26, 27) elektrische Leitungen (14) angeschlossen sind, die mit einer Schaltungsanordnung (15, 21) zur Messung der Differenzspannung der über jeweils zwei Batterieteilen (10, 26, 27) abfallenden Spannung elektrisch miteinander verbunden sind.

2. Überwachungseinrichtung nach Anspruch 1, dadurch gekennzeichnet, daß an den elektrischen Anschlüssen (11, 12, 13) jedes Batterieteiles (10) ein Spannungsmeßgerät (16) angeschlossen ist, deren Ausgänge zur Feststellung der Größe und Polarität einer Differenzspannung zwischen zwei Batterieteilen (10) mit einer Steuer- und/oder Überwachungssignale abgebenden Diagnoseeinrichtung (18) verbunden sind.

3. Überwachungseinrichtung nach Anspruch 1, gekennzeichnet durch eine Schaltungsanordnung (21) zur Messung der Differnzspannung jeweils zweier direkt hintereinander geschalteter Batterieteile (10, 26, 27), bei der jeweils parallel zu den beiden Batterieteilen (10, 26, 27) zwei in Reihe liegende Widerstände (22), insbesondere mit gleichem Widerstandswert, angeschlossen sind, und bei der zwischen dem Mittelabgriff (13) der beiden Batterieteile (10, 26, 27) und einem entsprechenden Mittelabgriff (23) zwischen den Widerständen (22)
ein Spannungsmeßgerät (24) angeschlossen ist.

4. Überwachungseinrichtung nach Anspruch 3, dadurch
gekennzeichnet, daß die Ausgänge (17) der Spannungsmeßgeräte (24) zur Feststellung der Größe und Polarität
einer Differenzspannung zwischen zwei Batterieteilen
(10. 26, 27) mit einer Steuer- und/oder Überwachungssignale abgebenden Diagnoseeinrichtung (25) verbunden sind.

5. Überwachungseinrichtung nach einem der Ansprüche 2 bis 4, dadurch gekennzeichnet, daß die Spannungsmeßgeräte (16) und/oder Differenzspannungsmeßgeräte (24) elektronische Differenzverstärker sind.

6. Überwachungseinrichtung nach einem der
Ansprüche 1 bis 5, dadurch gekennzeichnet, daß die
Stromversorgung der Schaltungsanordnung (15, 21),
insbesondere der Differenzverstärker, durch die zu
überwachende Batterie erfolgt.

Fig. 1

0080164

Fig. 2

Fig. 3

0080164

Fig. 4